# FASCICULE DE BREVET EUROPEEN

(11) **EP 2 533 063 B1**
(45) Date de publication et mention de la délivrance du brevet: **08.10.2014**
(21) Numéro de dépôt: 12165093.1
(22) Date de dépôt: 23.04.2012
(51) Int. Cl.: G01R 31/3185

(54) **Système d'analyse de données de test de semiconducteurs**
Analysesystem von Halbleitertestdaten
System for analysing semiconductor test data

(30) Priorité: 06.06.2011 FR 1154877
(43) Date de publication de la demande: 12.12.2012
(73) Titulaire: Qualtera, 34960 Montpellier (FR)
(72) Inventeur: Simon, Paul, 30250 VILLEVIELLE (FR); De Vries, Dirk Kenneth, 34680 SAINT GEORGES D'ORQUES (FR); Raymond, Thierry, 34790 GRABELS (FR)
(74) Mandataire: de Beaumont, Michel

(56) Documents cités:
- US-A1- 2007 035 322
- US-A1- 2008 172 190
- TANDON N ET AL: "Reduce your cycle time by utilizing automation for wafer test data collection", 28TH. IEEE/CPMT/SEMI INTERNATIONAL ELECTRONICS MANUFACTURING TECHNOLOGY SYMPOSIUM. (IEMT). SAN JOSE, CA, JULY 16 - 18, 2003; [IEEE/CPMT INTERNATIONAL ELECTRONICS MANUFACTURING TECHNOLOGY (IEMT) SYMPOSIUM], NEW YORK, NY : IEEE, US, 16 juillet 2003 (2003-07-16), pages 201-205, XP010655418, DOI: 10.1109/IEMT.2003.1225900 ISBN: 978-0-7803-7933-6

## Description

### Domaine de l'invention

La présente invention concerne un système et un procédé pour le traitement de données de test de semiconducteurs.

### Exposé de l'art antérieur

La demande de brevet US 2008/172190 A1 (LEE JONG-HYUN, 17 juillet 2008) décrit un procédé procédé de traitement de données de test de semiconducteurs.

Pendant la fabrication de circuits intégrés, une tranche de silicium est divisée en un certain nombre de zones élémentaires, chacune d'elles correspondant à un substrat de silicium rectangulaire sur lequel est formée une puce. En particulier, la tranche est soumise à des étapes de traitement de semiconducteurs, comme des étapes de photolithographie, de gravure, de dopage et de dépôt de divers matériaux, pour former chaque puce de chaque zone élémentaire. Ensuite, la tranche est découpée en zones élémentaires pour séparer les puces individuelles, qui sont ensuite mises dans des boîtiers pour former des circuits intégrés.

Pendant et après le processus de fabrication, divers tests de zones élémentaires de la tranche sont réalisés, ceux-ci pouvant inclure des tests de tri de tranche électriques et des tests électriques des circuits intégrés, appelés aussi ici "tests finaux". Le but de ces tests est de rejeter les zones élémentaires qui sont défectueuses, et/ou qui ne satisfont pas à certains critères.

Le nombre de zones élémentaires défectueuses par tranche a un impact direct sur le coût élémentaire de chaque circuit intégré fonctionnel qui sort de l'usine. Il existe donc un souhait dans l'industrie pour suivre la trace des causes qui entraînent des taux de rejet élevés de zones élémentaires dans la tranche de silicium, et pour corriger le processus de fabrication là où cela est possible. En effet, en général lorsqu'une zone élémentaire est rejetée, les circonstances du rejet sont enregistrées en classant chaque zone élémentaire d'après une certaine "case de test" dans laquelle elle tombe. Ces informations sont incluses dans les données de test associées à chaque tranche.

L'analyse des données du tri de tranche et des tests finaux est en générale réalisée manuellement par un analyste spécialisé, qui essaye de réaliser des déductions concernant les causes de rejet de certaines zones élémentaires sur la base des données de test. Ce processus d'analyse est consommateur de temps. Cela n'est pas souhaitable, étant donné que plus il s'écoule de temps avant qu'une action soit entreprise pour corriger le processus de fabrication, plus de zones élémentaires vont être rejetées pendant ce temps. En outre, le processus d'analyse est inefficace et irrégulier, étant donné qu'un seul analyste ne bénéficie pas nécessairement de l'expérience de collègues analystes et qu'il repose sur un jugement humain, qui peut varier d'un analyste à l'autre, et qui est sujet à des erreurs.

Il serait par conséquent souhaitable d'automatiser dans une certaine mesure le processus d'analyse, mais il y a des difficultés techniques pour faire cela.

### Résumé

Un objet de modes de réalisation de la présente invention est de répondre au moins partiellement à une ou plusieurs difficultés de l'art antérieur.

Selon un aspect de la présente invention, on prévoit un système pour traiter des données de test de semiconducteurs concernant une pluralité de zones élémentaires formées par un processus de fabrication sur au moins une tranche de silicium, le système comprenant : une entrée agencée pour recevoir les données de test de semiconducteurs ; une ou plusieurs mémoires adaptées pour mémoriser une base de données comprenant les données de test de semiconducteurs et une pluralité de modèles de données de test, chacun des modèles de données de test étant associé à une valeur de données de sortie correspondante indiquant une recommandation associée pour modifier le processus de fabrication ; et au moins un module de traitement agencé pour analyser les valeurs des données de test de semiconducteurs, et/ou des valeurs déduites des données de test de semiconducteurs, pour identifier une concordance avec au moins l'un des modèles de données de test, et pour fournir la valeur de données de sortie correspondante indiquant la recommandation associée.

Selon un mode de réalisation, un ou plusieurs des modèles de la pluralité de modèles de données de test comprennent un algorithme et ledit au moins un module de traitement est agencé pour exécuter ledit algorithme pour identifier la concordance avec au moins l'un des modèles de données de test.

Selon un autre mode de réalisation, un ou plusieurs des modèles de la pluralité de modèles de données de test définissent une plage d'une pluralité de valeurs des données de test de semiconducteurs ou déduites de celles-ci.

Selon un autre mode de réalisation, le système comprend en outre au moins une entrée adaptée pour recevoir une réponse d'un utilisateur à ladite valeur de données de sortie, ledit au moins un module de traitement étant en outre agencé pour adapter la valeur de données de sortie sur la base de la réponse de l'utilisateur.

Selon un autre mode de réalisation, ledit au moins un module de traitement est en outre agencé pour adapter au moins l'un de la pluralité de modèles de données de test sur la base de la réponse de l'utilisateur.

Selon un autre mode de réalisation, ledit au moins un module de traitement est en outre adapté à générer des statistiques de données de test sur la base desdites données de test de semiconducteurs, et comprend en outre une interface Web agencée pour présenter les statistiques de données de test sur une page Web.

Selon un autre mode de réalisation, ledit au moins un module de traitement est agencé pour analyser les statistiques de données de test pour identifier la concordance avec au moins l'un des modèles de données de test.

Selon un autre mode de réalisation, le système comprend en outre un équipement source de données adapté à fournir les données de test de semiconducteurs.

Selon un autre mode de réalisation, l'équipement source de données comprend un équipement de test de semiconducteurs adapté à tester les zones élémentaires d'une tranche de silicium avant de découper la tranche de silicium en zones élémentaires, et un équipement de test de produits adapté à tester les circuits intégrés produits à partir des zones élémentaires d'une tranche de silicium.

Selon un autre aspect de la présente invention, on prévoit un procédé de traitement de données de test de semiconducteurs concernant une pluralité de zones élémentaires formées par un processus de fabrication sur au moins une tranche de silicium, le procédé comprenant les étapes suivante : recevoir les données de test de semiconducteurs et mémoriser les données de test de semiconducteurs dans une base de données ; analyser des valeurs des données de test de semiconducteurs, et/ou des valeurs déduites des données de test de semiconducteurs, pour identifier une concordance avec un ou plusieurs modèles d'une pluralité de modèles de données de test, chacun des modèles de données de test étant associé à une valeur de données de sortie correspondante indiquant une recommandation associée pour modifier le processus de fabrication ; et sur la base desdites une ou plusieurs concordances identifiées, fournir la valeur de données de sortie correspondante indiquant la recommandation associée.

### Brève description des dessins

Les objets, fonctionnalités, aspects et avantages de l'invention susmentionnés, et d'autres, apparaîtront clairement à la lecture de la description détaillée suivante de modes de réalisation, donnés à titre d'illustration et non de limitation, en faisant référence aux dessins joints dans lesquels :
la figure 1 illustre une tranche de silicium selon un exemple ;
la figure 2 illustre un système pour traiter des données de test de semiconducteurs selon un mode de réalisation de la présente invention ;
les figures 3A et 3B sont des organigrammes illustrant des étapes d'un procédé de traitement de données de test de semiconducteurs selon des modes de réalisation de la présente invention ;
la figure 4 illustre schématiquement un dispositif destiné à traiter des données selon un mode de réalisation de la présente invention ; et
la figure 5 illustre une structure de mémoire mémorisant des représentations graphiques de statistiques de données de test selon un mode de réalisation de la présente invention.

### Description détaillée de modes de réalisation de l'invention

Seuls les aspects qui sont utiles à la compréhension de la présente description sont décrits en détail ici et sont illustrés dans les dessins. D'autres aspects comme les tests particuliers utilisés pour générer les données de test de semiconducteurs, comprenant par exemple des données de tri de tranches et/ou de test final, n'ont pas été décrits en détail, car il est évident pour l'homme de l'art que les enseignements de la présente description pourraient être appliqués à des données de test de semiconducteurs résultant d'une grande gamme de tests.

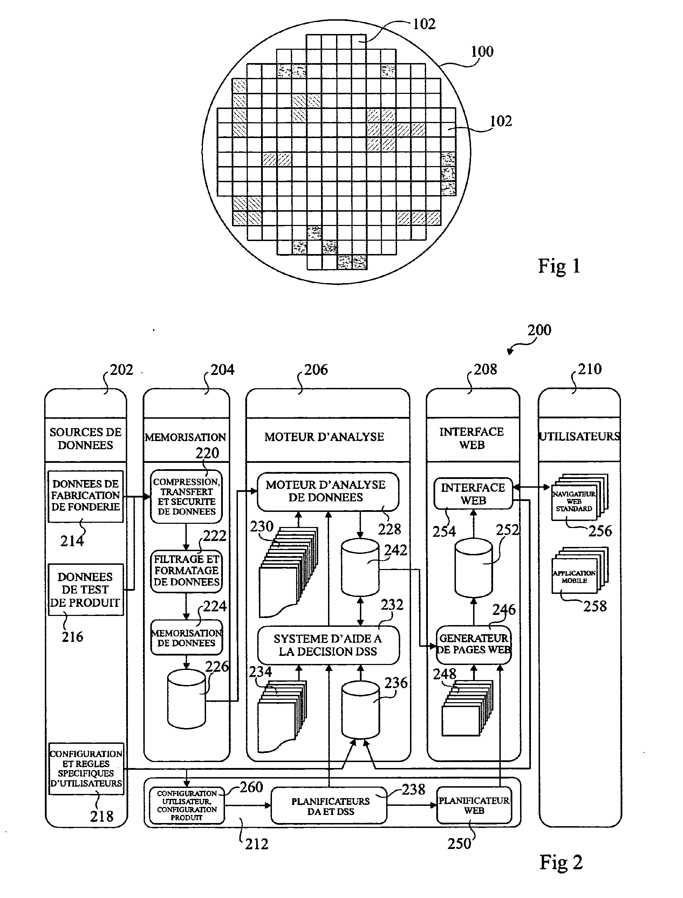

La figure 1 illustre schématiquement, en vue à plat, un exemple de tranche de silicium 100 et représente un exemple des informations formant les données de test de tri de tranche selon certains modes de réalisation décrits ici.

La tranche 100, qui a la forme d'un disque de silicium sensiblement circulaire, comprend un réseau de zones élémentaires rectangulaires 102, chacune d'elles correspondant à un circuit intégré. Comme cela a été expliqué précédemment, pendant et après le processus de fabrication, divers tests des zones élémentaires de la tranche sont réalisés, ceux-ci pouvant inclure des tests de sondage de tranche, des tests de tri de tranche électriques, et des tests électriques du circuit intégré. Une ou plusieurs des zones élémentaires peuvent être trouvées défectueuses, et classées dans un certains nombre de "cases de test", sur la base du défaut identifié. Dans l'exemple de la figure 1, les zones élémentaires, représentées sous forme de carrés vides ont réussi le test, tandis que les zones élémentaires représentées par des carrés pleins et des carrés hachurés en diagonale ont échoués aux tests pour un certain nombre de raisons.

Par exemple, les carrés pleins représentent des zones élémentaires qui ont échoué en raison de rayures sur la surface de la tranche, les carrés ayant des hachures en diagonale allant du bas à gauche vers le haut à droite représentent des zones élémentaires qui ont échoué en raison d'erreurs détectées pendant le test ou pendant la fabrication, et les carrés ayant des hachures en diagonale allant du bas à droite vers le haut à gauche représentent des zones élémentaires qui ne répondent pas à des limites de consommation d'énergie prédéfinies pour la puce.

Ainsi, dans un exemple, les données de test de semiconducteurs correspondent aux données résultant du test effectué sur chaque tranche, et comprennent le nombre total de zones élémentaires ayant échoué sur chaque tranche, le nombre de zones élémentaires ayant échoué dans chaque catégorie et/ou les emplacements sur chaque tranche des zones élémentaires ayant échoué, fournis par exemple sous forme de coordonnées x, y. Les données peuvent aussi inclure le nombre de zones élémentaires attribuées à une "case de test" particulière. En outre, les données peuvent inclure des statistiques sur des données paramétriques capturées pendant le processus de test, comme des valeurs moyennes ou médianes au niveau tranche de la fréquence de fonctionnement maximum (FMAX), la consommation d'énergie au repos, et/ou d'autres paramètres analogiques comme la distorsion harmonique totale (THD).

La figure 2 illustre schématiquement une vue d'ensemble d'un système 200 destiné à traiter des données de test de semiconducteurs selon un mode de réalisation.

Un certain nombre de sources de données 202 fournissent des données de test de semiconducteurs à un module de mémorisation 204, qui maintient une base de données avec des données de test de semiconducteurs. Les données de test de semiconducteurs sont ensuite analysées par un moteur d'analyse 206, qui à son tour communique avec un module d'interface Web 208, permettant de mettre les résultats de l'analyse à la disposition d'un équipement d'utilisateur 210. En outre, un module de commande 212 commande des aspects du moteur d'analyse 206 et du module d'interface Web 208 comme on va le décrire plus en détail ci-après.

Les sources de données 202 comprennent des données de fabrication de fonderie 214, qui sont des données de test de semiconducteurs provenant d'usines de fabrication. Ces données comprennent des mesures de paramètres des tranches, par exemple des données paramétriques recueillies sur des structures de test de chemins de coupe, comprenant par exemple des données PCM (Process Control Module ; module de contrôle de processus) et/ou de données WAT (Wafer Acceptance Test ; test d'acceptabilité de tranche). Les sources de données 202 comprennent aussi des données de test de produit 216, qui sont des données de test résultant d'un test fonctionnel du circuit intégré, et ces données proviennent par exemple de sites de test spécifiques. Les données de test de produit sont par exemple au format STDF (Standard Test Data Format ; format de données de test standard), bien que d'autres formats puissent être pris en charge. Les sources de données peuvent aussi inclure des données de paramétrage et des règles spécifiques d'utilisateurs 218, comme cela est décrit plus en détail ci-après.

Le module de mémorisation 204 comprend par exemple un module de transfert, de compression et de sécurité de données 220, qui reçoit les données de test de semiconducteurs 214, 216 et gère des protocoles de compression et/ou de sécurité qui ont été appliqués aux données, par exemple en appliquant une décompression et/ou un déchiffrement sur les données de test de semiconducteurs.

Les données de test provenant du module 220 sont fournies à un module de filtrage et de formatage de données 222, qui par exemple élimine par filtrage des données de test sans rapport avec l'objet du système 200 ainsi que des données dont l'intégrité ne peut être garantie, et standardise le format des données, par exemple en convertissant les données de test en un format spécifique.

Les données de test de semiconducteurs filtrées provenant du module 222 sont fournies à un module de mémorisation de données 224, qui mémorise les données dans une base de données 226, prêtes pour une analyse.

Le moteur d'analyse 206 comprend par exemple un moteur d'analyse de données 228, qui récupère les données de test de semiconducteurs dans la base de données 226, et les analyse sur la base d'un ensemble d'algorithmes et de règles d'analyse 230. Ces algorithmes et ces règles 230 définissent par exemple la façon dont les données doivent être traitées afin de générer des statistiques de données de test indiquant une tendance d'un ou plusieurs indicateurs extraits et/ou déduits des données de test. Les statistiques des données de test illustrent par exemple une évolution des indicateurs dans le temps ou suivant un certain nombre de tranches. Dans un exemple, les données de test pourraient montrer les fluctuations sur une semaine du pourcentage de zones élémentaires de chaque tranche ou de chaque lot de tranches qui a réussi tous les tests. Bien sûr, il y a de nombreux types d'indicateurs différents qui pourraient être déduits des données de test de semiconducteurs.

Le moteur d'analyse de données 206 reçoit aussi une entrée provenant d'un système d'aide à la décision 232, qui utilise des procédés et des algorithmes 234 mémorisés, et des connaissances acquises mémorisées dans un élément de mémorisation 236. Les procédés et algorithmes 234 permettent d'identifier certains modèles de données et des corrélations dans les données de test de semiconducteurs et/ou dans les statistiques de données de test. L'aide à la décision peut être basée directement sur les données de test, ou sur des données dérivées de celles-ci, et/ou sur une analyse additionnelle basée sur des modèles de données de test et des corrélations, par exemple en exécutant un flux d'analyse à étapes multiples qui prend, à chaque étape, certains ou la totalité des résultats obtenus précédemment, et génère de nouvelles données et/ou des modèles de données basés sur les résultats obtenus précédemment. Les modèles de données définissent une combinaison de certaines caractéristiques se trouvant dans les données de test de semiconducteurs ou dans les statistiques de données de test déduites des données de test de semiconducteurs, comme des valeurs dans certaines plages, ou une distribution spatiale particulière de zones élémentaires défectueuses. Dans un autre exemple, des creux et des pics soudains dans certaines statistiques de données de test, comme le pourcentage de zones élémentaires défectueuses, en combinaison avec certaines variations dans les paramètres de test, peuvent être reconnus automatiquement comme indiquant un certain problème dans le processus de fabrication.

Le système d'aide à la décision 232 est contrôlé par un planificateur de système d'analyse de données et d'aide à la décision de données 238 du circuit de commande 212, qui contrôle le moment où le système d'aide à la décision 232 est activé. Le moteur d'analyse de données 228 fournit des données de sortie, comprenant les statistiques de données de test et les données de test de semiconducteurs, à un composant de mémorisation 242. Le composant de mémorisation 242 est aussi accessible par le système d'aide à la décision 232, qui applique les procédés et algorithmes 234 aux données de test et aux statistiques de données de test afin de détecter les modèles de données dans les données mémorisées par le composant 242. Chaque modèle de données défini par les procédés et algorithmes 234 est associé à une recommandation correspondante pour modifier le processus de fabrication ou de test. Le système d'aide à la décision 232 génère ainsi, sur la base des modèles de données détectés, une ou plusieurs valeurs de données de sortie indiquant une recommandation associée pour modifier le processus de fabrication ou de test. Ces données de sortie sont par exemple mémorisées dans le composant de mémorisation 242.

Les données provenant du composant de mémorisation 242 sont fournies à un générateur de pages Web 246, qui utilise le résultat provenant du moteur d'analyse de données 228 pour générer des graphiques qui peuvent être fournis dans un format de page Web. En outre, il présente les recommandations disponibles dans un format lisible par un utilisateur. Par exemple, le générateur de pages Web 246 peut recevoir des modèles 248, sur la base desquels les statistiques de données de test et les recommandations sont affichées. Le générateur de pages Web 246 est par exemple contrôlé par le planificateur Web 250 du circuit de commande 212, qui contrôle le moment où sont générées de nouvelles données Web. Les données Web, formées des graphiques et des recommandations, sont ensuite mémorisées dans un composant mémoire 252, à partir duquel elles peuvent être accessibles par un utilisateur en réponse à une requête faite par l'intermédiaire d'un module d'interface Web 254.

Le module d'interface Web 254 est accessible, par exemple par l'intermédiaire de l'Internet, par le navigateur Web standard 256 d'un PC (ordinateur personnel) d'un utilisateur, et/ou par une application mobile 258 d'un dispositif de communication mobile. Le même système 200 peut mettre à disposition des données différentes pour des utilisateurs différents. Par exemple, un utilisateur peut souhaiter surveiller la production de tranches concernant son produit qui est une puce de processeur pour un ordinateur portable, tandis qu'un autre utilisateur peut souhaiter surveiller la production de tranches concernant son produit qui est un circuit intégré pour un téléphone mobile. Chaque utilisateur peut avoir accès seulement aux statistiques de données de test et aux recommandations concernant son produit, et cet accès restreint est par exemple contrôlé par des partitions protégées par mot de passe dans le dispositif de mémorisation 252.

L'interface Web 254 fournit aussi des données de retour d'utilisateur à la base de données de connaissance acquise 236. Ces données permettent d'identifier de nouveaux modèles dans les données de test, de sorte que le système apprend et est capable de faire de nouveaux types de recommandations sur la base de cette connaissance. Aussi, des règles d'utilisateurs 218 peuvent fournir d'autres critères pour déterminer les modèles de données de test.

De plus, le circuit de commande 212 comprend un module de configuration d'utilisateur et de configuration de produit 260, qui définit des paramètres d'utilisateurs et de produits, comme des droits d'accès d'utilisateurs à certaines données de produits, et à des données physiques, logistiques et de conception associées aux produits.

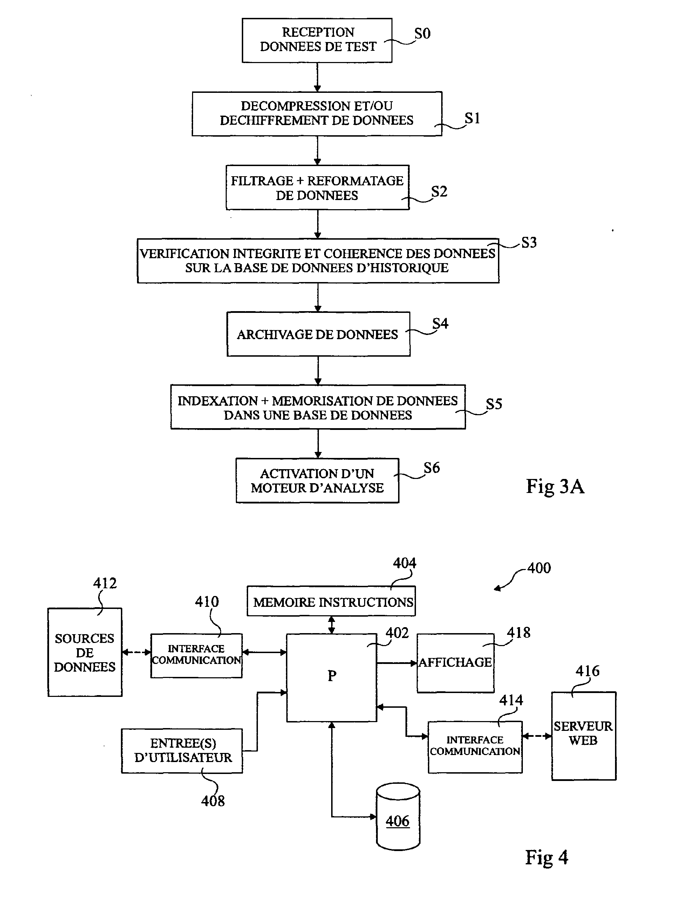

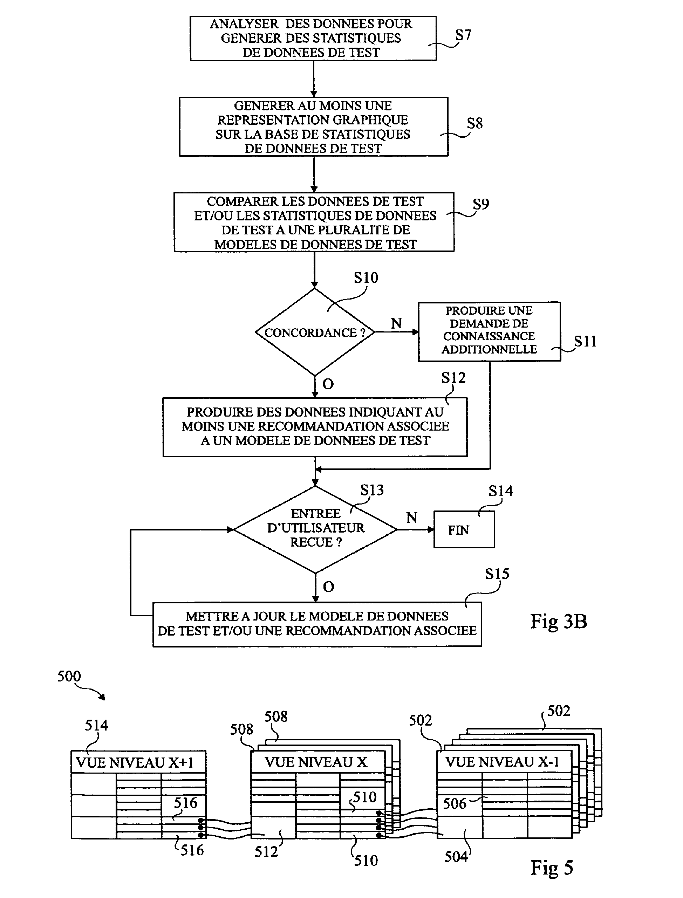

On va maintenant décrire plus en détail le fonctionnement du système 200 de la figure 2, en faisant référence aux organigrammes des figures 3A et 3B.

En référence à la figure 3A, dans une première étape S0, de nouvelles données de test de semiconducteurs sont reçues par le module source de données 202 de la figure 2.

Dans une étape suivante S1, une décompression et/ou un déchiffrement des données sont réalisés par le bloc 220. Par exemple, dans le cas où les données sont transmises par l'intermédiaire du réseau Internet vers le module de mémorisation 204, on peut utiliser un chiffrement pour assurer la sécurité vis-à-vis de tiers ayant accès aux données. En outre, on peut utiliser une compression pour réduire la taille des fichiers transmis et ainsi réduire les exigences de largeur de bande en transmission.

Dans une étape suivante S2, un filtrage et un reformatage des données sont réalisés, ceux-ci, comme décrit précédemment, pouvant impliquer le retrait de données de test sans objet, et le reformatage des données en un format normalisé spécifique.

Dans une étape suivante S3, une vérification de l'intégrité et de la cohérence des données est réalisée, par exemple sur la base de données d'historique. Cela implique par exemple de vérifier que les données sont dans les plages attendues, et que des données sont présentes pour tous les zones élémentaires sur la tranche.

Dans une étape suivante S4, un archivage de données est réalisé optionnellement, celui-ci impliquant par exemple la sauvegarde des données filtrées et formatées dans un stockage à long terme.

Dans une étape suivante S5, les données sont introduites dans la base de données 226, et les données sont indexées, de telle sorte qu'elles puissent être accédées par le moteur d'analyse 206 de la figure 2 dans des étapes ultérieures.

Dans une étape S6, le moteur d'analyse 206 est activé, par exemple par le planificateur 238 de la figure 2.

En référence à la figure 3B, on va maintenant décrire un exemple des étapes réalisées ensuite par le moteur d'analyse 206.

Dans une étape S7, les données de test de semiconducteurs sont analysées pour générer des statistiques de données de test, par exemple en extrayant ou en déduisant certains indicateurs des données de test de semiconducteurs déterminées précédemment, sur la base des algorithmes et des règles 230.

Dans une étape suivante S8, les statistiques de données de test sont transformées en représentations graphiques, de sorte qu'elles puissent être affichées à un utilisateur par l'intermédiaire d'une interface Web.

Dans une étape suivante S9, le système d'aide à la décision 232 de la figure 2 compare les données de test de semiconducteurs et/ou les statistiques de données de test à une pluralité de modèles de données de test. Comme cela a été décrit précédemment, une telle comparaison peut être réalisée en exécutant un algorithme qui traite les données de test de semiconducteurs et/ou les statistiques de données de test et fournit l'indication d'une correspondance avec un ou plusieurs des modèles de données de test.

Dans une étape suivante S10, on détermine s'il y a eu une concordance entre les données de test ou les statistiques et un ou plusieurs des modèles de données de test. Dans la négative, l'étape suivante est S11, dans laquelle l'utilisateur se voit demander de fournir de la connaissance additionnelle au système, indiquant toute conclusion qui peut être tirée des données de test. A titre de variante, si une ou plusieurs concordances ont lieu, l'étape suivante est S12.

Dans l'étape S12, des données de sortie sont générées indiquant au moins une recommandation associée avec les modèles de données de test identifiés. La recommandation indique comment le processus de fabrication peut être corrigé et ainsi amélioré.

Après l'étape S11 ou S12, l'étape suivante est S13, dans laquelle on détermine si on a reçu ou pas une entrée d'utilisateur. En particulier, dans l'étape S12, la recommandation est fournie par l'intermédiaire de l'interface Web à un ou plusieurs utilisateurs, qui peuvent ne pas être d'accord avec la recommandation ou avoir des suggestions additionnelles pour les conclusions qui peuvent être tirées des données. Dans un tel cas, l'utilisateur peut soumettre des diagnostics alternatifs ou additionnels, et des recommandations correspondantes.

Si aucune entrée d'utilisateur de la sorte n'est reçue dans l'étape S13, l'étape suivante est S14, dans laquelle le processus se termine jusqu'à la réception de nouvelles données de test. A titre de variante, si une entrée d'utilisateur est reçue, l'étape suivante est S15, dans laquelle le retour d'utilisateur est utilisé pour adapter au moins l'une des recommandations et/ou ajouter un ou plusieurs nouveaux algorithmes dans la base de données de connaissance 236. Après l'étape S15, le procédé revient à l'étape S13, donnant à l'utilisateur une autre opportunité de fournir un retour sur la base des recommandations adaptées.

La figure 4 illustre un dispositif 400 qui peut être agencé pour mettre en oeuvre le procédé décrit ici.

Le dispositif 400 comprend un module de traitement P 402, qui peut être un processeur multicoeur, et est par exemple contrôlé par une mémoire d'instructions 404. En particulier, la mémoire d'instructions 404 mémorise par exemple des groupes d'instructions qui amènent le module de traitement 402 à mettre en oeuvre les étapes des figures 3A et 3B.

Le module de traitement 402 est aussi en communication avec un stockage en mémoire 406, qui peut comprendre un ou plusieurs dispositifs de mémoire volatile ou non volatile mémorisant les données de test de semiconducteurs, les statistiques de données de test, les pages Web et la connaissance acquise, mettant ainsi en oeuvre les composants de mémorisation 224, 236, 242 et 252 de la figure 2.

Une ou plusieurs entrées d'utilisateur 408 sont fournies au module de traitement 402, qui pourraient inclure un clavier et une souris, et correspondre par exemple aux entrées de commande d'un administrateur.

Une interface de communication 410 est par exemple couplée au module de traitement 402, et permet de recevoir les données d'entrée provenant des sources de données 412, par exemple par l'intermédiaire d'un réseau comme le réseau Internet. En outre, une interface de communication 414 peut être couplée au module de traitement 402 pour communiquer avec un serveur Web 416, sur lequel les pages Web affichant les statistiques de données de test et les recommandations peuvent être hébergées.

Un afficheur 418 est par exemple présent, pour permettre à un administrateur du système de modifier le système.

Bien qu'un seul dispositif 400 soit illustré pour mettre en oeuvre les diverses parties du système 200 de la figure 2, dans des variantes de réalisation, un ou plusieurs des modules 202, 204, 206, 208 et 212 peuvent mis en oeuvre par différents dispositifs similaires au dispositif 400 en communication entre eux.

La figure 5 illustre une structure de mémoire 500, maintenue par exemple dans la mémoire 242 et/ou 252 de la figure 2, et mémorisant les données utilisées pour générer les représentations graphiques des statistiques de données de test.

Comme cela est illustré en figure 5, la structure de mémoire comprend par exemple une pluralité de vues de niveau X-1 502. Le niveau X-1 correspond par exemple à une vue au niveau tranche des statistiques de données de test, et chaque vue 502 comprend certains champs de données 504, 506, indiquant par exemple des éléments des données de test comme le pourcentage de zones élémentaires réussies, le nombre de zones élémentaires tombant dans une certaine case, etc.

La structure de mémoire comprend aussi une pluralité de vues de niveau X 508. Le niveau X correspond par exemple à une vue au niveau lot, indiquant des statistiques de données de test ayant rapport à un lot particulier de, par exemple, 20 tranches. Dans la vue de niveau X, des données présentes dans les vues X-1 502 peuvent "remonter" et être reproduites. Par exemple, des champs 510 de la vue de niveau X reproduisent par exemple une valeur de statistique de données de test 504 de chacune ou de certaines des vues de niveau X-1. Dans un exemple particulier, chaque vue au niveau tranche 502 peut inclure un champ indiquant la perte de rendement, et la vue au niveau lot peut indiquer des motifs de perte de rendement extraordinaires ou des écarts paramétriques statiquement significatifs dans les tranches formant le lot. La vue de niveau X comprend aussi par exemple des champs mémorisant d'autres données statistiques, comme un champ 512, qui indique par exemple le nombre de tranches dans le lot qui ont plus d'un certain pourcentage de zones élémentaires réussies.

La structure de mémoire 500 comprend aussi une vue de niveau X+1 514, qui est par exemple une vue représentant la tendance du rendement pour une série de lots. Ici encore, des données provenant du niveau inférieur, dans ce cas la vue de niveau X, peuvent remonter jusqu'à la vue de niveau X+1, et dans cet exemple un champ 516 reproduit par exemple le champ de données 512 pour au moins certaines des vues au niveau lot 508. Par exemple, ce champ de données comprend du texte indiquant une explication possible pour une perte de rendement élevée pour chaque lot, et une recommandation correspondante.

Ainsi, les vues de chacun des niveaux X-1, X et X+1 de la figure 5 peuvent toutes être basées sur des données de test brutes, et en plus elles peuvent résumer des données générées par les vues de niveau inférieur, si ces données sont déterminées comme étant significatives au niveau supérieur.

Un avantage des modes de réalisation décrits ici est que, en détectant la présence d'un ou plusieurs modèles de données de test dans les valeurs de données de test de semiconducteurs ou des valeurs déduites à partir de celles-ci, chacun des modèles de données de test étant associé à une recommandation correspondante, les recommandations pour améliorer un processus de fabrication peuvent être générées de façon rapide et efficace.

Avec la description ainsi faite d'au moins un mode de réalisation illustratif de l'invention, divers changements, diverses modifications et améliorations apparaîtront facilement à l'homme de l'art.

Par exemple, il sera clair que les modes de réalisation décrits ici peuvent être mis en oeuvre par diverses combinaisons de matériel et/ou de logiciel. En outre, les diverses fonctionnalités décrites en relation avec les divers modes de réalisation pourraient être combinées selon une combinaison quelconque dans des variantes de réalisation.

## Revendications

1. Système pour traiter des données de test de semiconducteurs concernant une pluralité de zones élémentaires formées par un processus de fabrication sur au moins une tranche de silicium, le système comprenant :
une entrée agencée pour recevoir les données de test de semiconducteurs (202) ;
une ou plusieurs mémoires (226, 242) adaptées pour mémoriser une base de données comprenant les données de test de semiconducteurs et une pluralité de modèles de données de test, chacun des modèles de données de test étant associé à une valeur de données de sortie correspondante indiquant une recommandation associée pour modifier le processus de fabrication ; et
au moins un module de traitement (232) agencé pour analyser les valeurs des données de test de semiconducteurs, et/ou des valeurs déduites des données de test de semiconducteurs, pour identifier une concordance avec au moins l'un des modèles de données de test, et pour fournir la valeur de données de sortie correspondante indiquant la recommandation associée.

2. Système selon la revendication 1, dans lequel un ou plusieurs des modèles de la pluralité de modèles de données de test comprennent un algorithme et dans lequel ledit au moins un module de traitement est agencé pour exécuter ledit algorithme pour identifier la concordance avec au moins l'un des modèles de données de test.

3. Système selon la revendication 1 ou 2, dans lequel un ou plusieurs des modèles de la pluralité de modèles de données de test définissent une plage d'une pluralité de valeurs des données de test de semiconducteurs ou déduites de celles-ci.

4. Système selon l'une quelconque des revendications 1 à 3, comprenant en outre au moins une entrée adaptée pour recevoir une réponse d'un utilisateur à ladite valeur de données de sortie, ledit au moins un module de traitement (232) étant en outre agencé pour adapter la valeur de données de sortie sur la base de la réponse de l'utilisateur.

5. Système selon la revendication 4, dans lequel ledit au moins un module de traitement (232) est en outre agencé pour adapter au moins l'un de la pluralité de modèles de données de test sur la base de la réponse de l'utilisateur.

6. Système selon l'une quelconque des revendications 1 à 5, dans lequel ledit au moins un module de traitement (228) est en outre adapté à générer des statistiques de données de test sur la base des données de test de semiconducteurs, et comprenant en outre une interface Web (208) agencée pour présenter les statistiques de données de test sur une page Web.

7. Système selon la revendication 6, dans lequel ledit au moins un module de traitement (232) est agencé pour analyser les statistiques de données de test pour identifier la concordance avec au moins l'un des modèles de données de test.

8. Système selon l'une quelconque des revendications 1 à 7, comprenant en outre un équipement source de données adapté à fournir les données de test de semiconducteurs.

9. Système selon la revendication 8, dans lequel l'équipement source de données comprend un équipement de test de semiconducteurs adapté à tester les zones élémentaires d'une tranche de silicium avant de découper la tranche de silicium en zones élémentaires, et un équipement de test de produits adapté à tester les circuits intégrés produits à partir des zones élémentaires d'une tranche de silicium.

10. Procédé de traitement de données de test de semiconducteurs concernant une pluralité de zones élémentaires formées par un processus de fabrication sur au moins une tranche de silicium, le procédé comprenant les étapes suivantes :
recevoir les données de test de semiconducteurs et mémoriser les données de test de semiconducteurs dans une base de données (226) ;
analyser des valeurs des données de test de semiconducteurs, et/ou des valeurs déduites des données de test de semiconducteurs, pour identifier une concordance avec un ou plusieurs modèles d'une pluralité de modèles de données de test, chacun des modèles de données de test étant associé à une valeur de données de sortie correspondante indiquant une recommandation associée pour modifier le processus de fabrication ; et
sur la base desdites une ou plusieurs concordances identifiées, fournir la valeur de données de sortie correspondante indiquant la recommandation associée.

## Patentansprüche

1. Ein System zum Verarbeiten von Halbleiter-Testdaten, welche sich auf eine Vielzahl von elementaren Bereichen, die durch einen Herstellungsprozess auf wenigstens einem Siliziumwafer ausgebildet werden beziehen, wobei das System Folgendes aufweist:
einen Eingang, der angeordnet ist zum Empfang der Halbleiter-Testdaten (202);
einen oder mehrere Speicher (226, 242), die geeignet sind zum Speichern einer Datenbank, welche die Halbleiter-Testdaten und eine Vielzahl von Testdatenmustern aufweist, wobei jedes der Testdatenmuster assoziiert ist mit einem entsprechenden Ausgangsdatenwert, der eine assoziierte Empfehlung zum Modifizieren des Herstellungsprozesses anzeigt; und
wenigstens eine Verarbeitungseinheit (232), die konfiguriert ist zum Analysieren der Werte der Halbleiter-Testdaten, und/oder Werte die von den Halbleiter-Testdaten abgeleitet werden, zum Identifizieren einer Übereinstimmung mit wenigstens einem der Testdatenmuster und zum Ausgeben des entsprechenden Ausgangsdatenwertes, das die assoziierte Empfehlung anzeigt.

2. System nach Anspruch 1, wobei eines oder mehrere der Vielzahl von Testdatenmustern einen Algorithmus aufweist, und wobei die wenigstens eine Verarbeitungseinheit konfiguriert ist zum Ausführen des Algorithmus zum Identifizieren der Übereinstimmung mit wenigstens einem der Testdatenmuster.

3. System nach Anspruch 1 oder 2, wobei eines oder mehrere der Vielzahl von Testdatenmustern einen Bereich einer Vielzahl von Werten der Halbleiter-Testdaten oder abgeleitet aus den Halbleiter-Testdaten definiert.

4. System nach einem der Ansprüche 1 bis 3, das ferner wenigstens einen Eingang aufweist, der geeignet ist zum Empfangen einer Nutzerantwort auf den Ausgangsdatenwert, wobei die wenigstens eine Verarbeitungseinheit (232) ferner konfiguriert ist zum Adaptieren des Ausgangsdatenwertes, basierend auf der Nutzerantwort.

5. System nach Anspruch 4, wobei die wenigstens eine Verarbeitungseinheit (232) ferner konfiguriert ist zum Adaptieren wenigstens eines der Vielzahl von Testdatenmustern, basierend auf der Nutzerantwort.

6. System nach einem der Ansprüche 1 bis 5, wobei die wenigstens eine Verarbeitungseinheit (228) ferner geeignet ist zum Erzeugen von Testdatenstatistiken, basierend auf den Halbleiter-Testdaten, und das ferner ein Web-Interface (208) aufweist, das konfiguriert ist zum Präsentieren der Testdatenstatistiken auf einer Web-Page.

7. System nach Anspruch 6, wobei die wenigstens eine Verarbeitungseinheit (232) konfiguriert ist zum Analysieren der Testdatenstatistiken zum Identifizieren der Übereinstimmung mit wenigstens einem der Testdatenmuster.

8. System nach einem der Ansprüche 1 bis 7, das ferner eine Datenquellenausrüstung aufweist, die geeignet ist zum Liefern der Halbleiter-Testdaten.

9. System nach Anspruch 8, wobei die Datenquellenausrüstung eine Halbleitertestausrüstung aufweist, die geeignet ist zum Testen der elementaren Bereiche eines Halbleiterwafers vor dem Schneiden bzw. Dicing des Siliziumwafers und Produkttestausrüstung, die geeignet ist zum Testen der integrierten Schaltungen, die aus den elementaren Bereichen eines Siliziumwafers hergestellt werden.

10. Verfahren zum Verarbeiten von Halbleiter-Testdaten, die sich auf eine Vielzahl von elementaren Bereichen beziehen, die durch einen Herstellungsprozess auf wenigstens einem Siliziumwafer hergestellt wurden, wobei das Verfahren Folgendes aufweist:
Empfangen der Halbleiter-Testdaten und Speichern der Halbleiter-Testdaten in einer Datenbank (226);
Analysieren von Werten der Halbleiter-Testdaten, und/oder von Werten die von den Halbleiter-Testdaten abgeleitet wurden, zum Identifizieren einer Übereinstimmung mit einem oder mehreren einer Vielzahl von Testdatenmustern, wobei jedes der Testdatenmuster mit einem entsprechenden Ausgangsdatenwert assoziiert ist, der eine assoziierte Empfehlung zum Modifizieren des Herstellungsprozesses anzeigt; und
basierend auf der identifizierten einen oder mehreren Übereinstimmung(en), Ausgeben des entsprechenden Ausgangsdatenwertes, der die assoziierte Empfehlung anzeigt.

## Claims

1. A system for processing semiconductor test data relating to a plurality of elementary regions formed by a manufacturing process on at least one silicon wafer, the system comprising:
an input arranged to receive said semiconductor test data (202);
one or more memories (226, 242) adapted to store a database comprising said semiconductor test data and a plurality of test data patterns, wherein each of said test data patterns is associated with a corresponding output data value indicating an associated recommendation for modifying said manufacturing process; and
at least one processing unit (232) configured to analyse the values of said semiconductor test data, and/or values derived from said semiconductor test data, to identify a match with at least one of said test data patterns, and to output the corresponding output data value indicating the associated recommendation.

2. The system of claim 1, wherein one or more of said plurality of test data patterns comprises an algorithm, and wherein said at least one processing unit is configured to execute said algorithm to identify the match with at least one of said test data patterns.

3. The system of claim 1 or 2, wherein one or more of said plurality of test data patterns defines a range of a plurality of values of or derived from said semiconductor test data.

4. The system of any of claims 1 to 3, further comprising at least one input adapted to receive a user response to said output data value, wherein said at least one processing unit (232) is further configured to adapt said output data value based on said user response.

5. The system of claim 4, wherein said at least one processing unit (232) is further configured to adapt at least one of said plurality of test data patterns based on said user response.

6. The system of any of claims 1 to 5, wherein said at least one processing unit (228) is further adapted to generate test data statistics based on said semiconductor test data, and further comprising a Web interface (208) configured to present said test data statistics on a Web page.

7. The system of claim 6, wherein the at least one processing unit (232) is configured to analyse said test data statistics to identify said match with at least one of said test data patterns.

8. The system of any of claims 1 to 7, further comprising data source equipment adapted to supply said semiconductor test data.

9. The system of claim 8, wherein said data source equipment comprises semiconductor test equipment adapted to test the elementary regions of a silicon wafer prior to dicing of the silicon wafer, and product test equipment adapted to test the integrated circuits produced from the elementary regions of a silicon wafer.

10. A method of processing semiconductor test data relating to a plurality of elementary regions formed by a manufacturing process on at least one silicon wafer, the method comprising:
receiving said semiconductor test data and storing said semiconductor test data in a database (226);
analysing values of said semiconductor test data, and/or values derived from said semiconductor test data, to identify a match with one or more of a plurality of test data patterns, each of said test data patterns being associated with a corresponding output data value indicating an associated recommendation for modifying said manufacturing process; and
based on the identified one or more matches, outputting the corresponding output data value indicating the associated recommendation.
